# EUROPEAN PATENT APPLICATION

(11) **EP 4 583 154 A2**
(43) Date of publication of application: **09.07.2025**
(21) Application number: 24221274.4
(22) Date of filing: 18.12.2024
(51) Int. Cl.: H01L 21/67, H01L 21/673, H01L 21/677

(54) **SUBSTRATE PROCESSING APPARATUS, METHOD OF MANUFACTURING SEMICONDUCTOR DEVICE AND PROGRAM**

(30) Priority: 05.01.2024 JP 2024000737
(71) Applicant: Kokusai Electric Corp., Tokyo 1010045 (JP)
(72) Inventor: KITAMOTO, Hiroyuki, Toyama-shi, 939-2393 (JP); HISADA, Taku, Toyama-shi, 939-2393 (JP)
(74) Representative: Verscht, Thomas Kurt Albert

(57) **Abstract**

It is possible to suppress a decrease in work efficiency in an initial position setting operation for a substrate processing apparatus. There is provided a technique that includes: transporters each provided with one or more transfer shafts; a manipulator for selecting a specified transfer shaft from the one or more transfer shafts and performing an initial position setting therefor; a display for displaying a status of the initial position setting for the specified transfer shaft; and a controller including a determination processor and notifying a determination result determined by the determination processor, wherein the determination processor determines whether the initial position setting for the specified transfer shaft selected by the manipulator is completed and whether it is possible for an initial position setting for another transfer shaft to be performed in parallel.

## Description

### [Technical Field]

The present disclosure relates to a substrate processing apparatus, a method of manufacturing a semiconductor device and a program.

### [Related Art]

For example, a substrate processing apparatus and a method of manufacturing a semiconductor device may be used (for example, see Patent Document 1).

### [Related Art Document]

### [Patent Document]

Patent Document 1: Japanese Patent Laid-Open No. 2012-169534.

### [Disclosure]

### [Technical Problem]

According to the present disclosure, there is provided a technique capable of suppressing a decrease in work efficiency in an initial position setting operation for a substrate processing apparatus.

### [Technical Solution]

According to an embodiment of the present disclosure, there is provided a technique that includes: a plurality of transporters each provided with one or more transfer shafts and configured to transfer a substrate or a container accommodating the substrate; a manipulator configured to be capable of selecting a specified transfer shaft from the one or more transfer shafts and capable of performing an initial position setting for the specified transfer shaft; a display configured to display a status of the initial position setting for the specified transfer shaft; and a controller provided with a determination processor and configured to be capable of notifying a determination result determined by the determination processor, wherein the determination processor is configured to determine whether or not the initial position setting for the specified transfer shaft selected by the manipulator is completed and to determine whether or not it is possible for an initial position setting for another transfer shaft to be performed in parallel with the initial position setting for the specified transfer shaft.

### [Advantageous Effects]

It is possible to suppress a decrease in work efficiency in an initial position setting operation for a substrate processing apparatus.

### [Brief Description of Drawings]

FIG. 1 is a diagram schematically illustrating an overall configuration of a substrate processing apparatus used in one or more embodiments of the present disclosure.
FIG. 2 is a diagram schematically illustrating a vertical cross-section of the substrate processing apparatus used in the embodiments of the present disclosure.
FIG. 3 is a block diagram schematically illustrating a configuration of a controller and related components of the substrate processing apparatus used in the embodiments of the present disclosure.
FIG. 4 is a diagram schematically illustrating an example of a screen displayed on a display of the substrate processing apparatus used in the embodiments of the present disclosure.
FIG. 5 is a flowchart schematically illustrating an original position setting procedure according to the embodiments of the present disclosure.
FIG. 6 is a diagram schematically illustrating a table indicating a correspondence between transfer shafts according to the embodiments of the present disclosure.
FIG. 7 is a sequence diagram schematically illustrating sequences performed by the controller according to the embodiments of the present disclosure.
FIG. 8 is a diagram schematically illustrating another example of the screen displayed on the display of the substrate processing apparatus used in the embodiments of the present disclosure.

### [Detailed Description]

### <Embodiments of Present Disclosure>

Hereinafter, one or more embodiments (also simply referred to as "embodiments") according to the technique of the present disclosure will be described with reference to the drawings. In the drawings, the same or equivalent constituents are designated by the same reference numerals. In addition, a dimensional ratio in the drawings may be exaggerated for convenience of explanation, and may differ from the actual ratio.

Further, in the description of the present disclosure, the term "operator" is not limited to a specific person. That is, the operator may refer to a person performing a task, or may refer to a group of persons performing the task.

Further, in the description of the present disclosure, the term "transfer shaft" may refer to one or both of the following: first, a shaft line related to a direction in which a transfer object (that is, an object to be transferred) is moved linearly in a predetermined direction.; and second, a shaft line indicating a center of a rotation shaft (or a rotation axis) when the transfer object is rotated in a predetermined direction.

Further, according to the present embodiments, an appropriate apparatus may be used for a linear mover (which is a linear moving structure) configured to move the transfer object linearly or a rotator (which is a rotating structure) configured to move the transfer object rotationally.

Further, in the following description, the term "select" may refer to a case where the operator selects a specified configuration (or specified configurations) among a plurality of configurations. In other words, the term "select" may refer to a case where the operator sets the specified configuration (or the specified configurations) in a state in which the specified configuration (or the specified configurations) can be operated as intended by the operator or another operator.

Further, in the following description, the "can be selected" (or "can select") may refer to a state in which, when the operator selects a specified transfer shaft (or specified transfer shafts) among a plurality of transfer shafts, the operator can operate a configuration (or configurations) related to the specified transfer shaft (or the specified transfer shafts). Similarly, the term "cannot be selected" (or "cannot select") may refer to a state in which, even when the operator selects the specified transfer shaft (or the specified transfer shafts) among the plurality of transfer shafts, the operator cannot operate the configuration (or the configurations) related to the specified transfer shaft (or the specified transfer shafts).

Further, in the following description, the term "selectable" may refer to a state in which it is possible to transition to another state in which the operator can operate the specified configuration (or the specified configurations) as intended by selecting the specified configuration (or the specified configurations) among the plurality of configurations. Similarly, the term "non-selectable" may refer to a state in which it is possible to transition to another state in which the operator can operate the specified configuration (or the specified configurations) as intended by selecting the specified configuration (or the specified configurations) among the plurality of configurations.

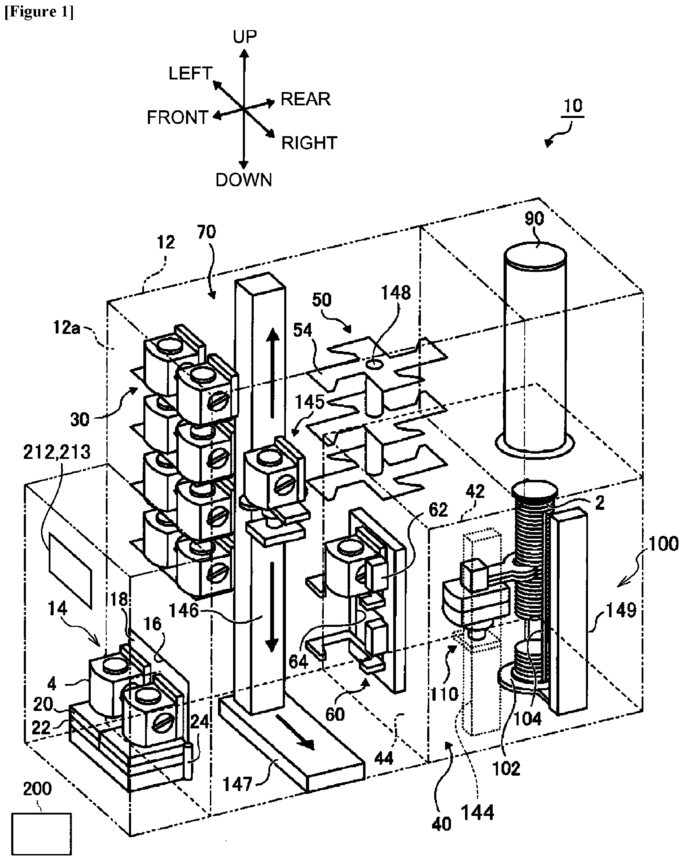

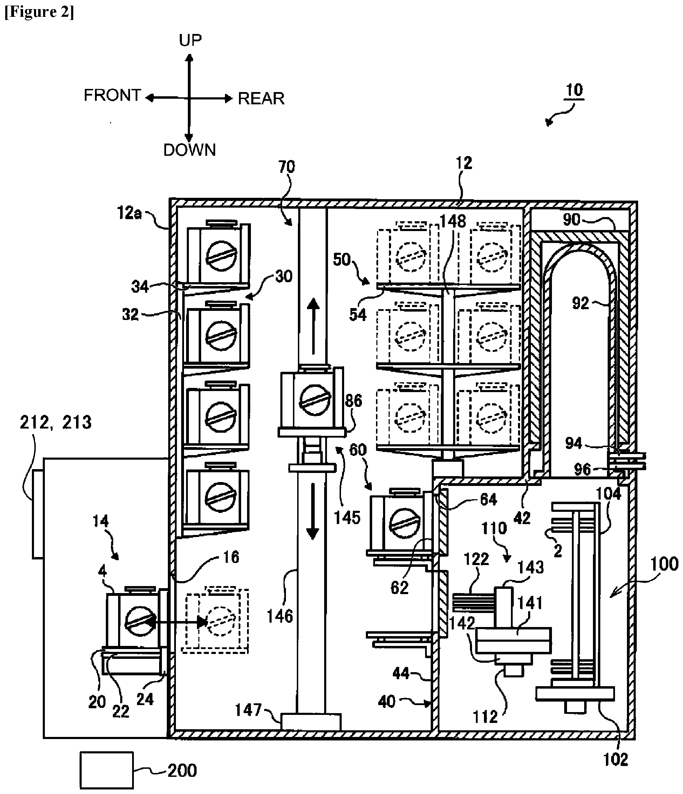

FIGS. 1 and 2 are diagrams schematically illustrating a substrate processing apparatus 10 according to the present embodiments. According to the present embodiments, the substrate processing apparatus 10 is configured as a vertical type apparatus configured to perform a process such as an oxidation process, a diffusion process and a CVD (Chemical Vapor Deposition) process on a substrate 2. In the substrate processing apparatus 10, for example, a FOUP (Front Opening Unified Pod, hereinafter also referred to as a "container 4") serves as a substrate container (substrate carrier) configured to store the substrate 2. For example, the substrate 2 is made of a material such as silicon (Si). When the container 4 is used as the substrate carrier, since the substrate 2 is transferred in a sealed state, it is possible to improve a cleanliness of the substrate 2.

### <Configuration>

As shown in FIGS. 1 and 2, the substrate processing apparatus 10 includes a substrate processing apparatus main structure 12, a manipulator 212, a display 213, a controller 200 and a plurality of transporters (which are transport structures).

As described above, the substrate processing apparatus 10 is provided with the substrate processing apparatus main structure 12. At a front wall 12a of the substrate processing apparatus main structure 12, a loading/unloading structure 14 configured to transfer (load) the container 4 into and to transfer (unload) the container 4 out of the substrate processing apparatus main structure 12 is provided. Further, at the front wall 12a, a loading/unloading port 16 configured to communicate between an inside (inner portion) and an outside (outer portion) of the substrate processing apparatus main structure 12 is provided. The loading/unloading port 16 is configured to be opened and closed by an opening/closing structure (also referred to as an "opener/closer") 18.

For example, the loading/unloading structure 14 is constituted by: a mounting table (mounting stage) 20 on which the container 4 is placed; a transfer structure 22 configured to transfer the mounting table 20 in a front-rear direction; and a rotator 24 configured by a component such as a hinge and configured to be capable of rotating the mounting table 20 and the transfer structure 22. According to the present embodiments, two mounting tables including the mounting table 20 and two transfer structures including the transfer structure 22 may be provided side by side in a left-right direction. Hereinafter, each of the two mounting tables may also be referred to as the "mounting table 20", and each of the two transfer structures may also be referred to as the "transfer structure 22".

By transferring the mounting table 20 in the front-rear direction by the transfer structure 22, the container 4 placed on the mounting table 20 moves between the inside and the outside of the substrate processing apparatus main structure 12 through the loading/unloading port 16. In a manner described above, the transfer structure 22 transfers the mounting table 20 between a loading/unloading position and a transfer position (also referred to as a "delivery position"). The loading/unloading position refers to a position which is located outside the substrate processing apparatus main structure 12 and where the container 4 is transferred to and from an external transfer apparatus (not shown). In addition, the transfer position refers to a position which is located inside the substrate processing apparatus main structure 12 and where the container 4 is transferred to and from a container transfer apparatus 70 described later.

For example, during a maintenance operation for the inside of the substrate processing apparatus main structure 12, the mounting table 20 and the transfer structure 22 are rotated forward.

A buffer shelf 30 (which is used as a first storage configured to store a plurality of containers including the container 4) is provided in an upper portion of the substrate processing apparatus main structure 12 at a rear of the loading/unloading structure 14. The buffer shelf 30 is provided to separate the loading/unloading structure 14 from the container transfer apparatus 70. Hereinafter, the plurality of containers including the container 4 may also be referred to as "containers 4".

The buffer shelf 30 is constituted by a support plate 32 attached to an inner surface of the front wall 12a and a plurality of shelf plates 34 supported horizontally by the support plate 32. The buffer shelf 30 is configured such that the containers (for example, two containers) 4 can be arranged on each of the shelf plates 34 side by side in the left-right direction.

A sub-housing 40 is provided at a rear lower portion of the substrate processing apparatus main structure 12. A space (which is fluidically isolated from an inner space of the substrate processing apparatus main structure 12) is provided by a horizontal wall 42 (which extends in the front-rear direction) and a vertical wall 44 (which extends in an up-down direction, that is, a vertical direction) of the sub-housing 40.

### <Transporter>

According to the present embodiments, for example, the plurality of transporters may include a substrate transfer apparatus 110, the container transfer apparatus 70, a container storage shelf 50 and a support structure transfer apparatus 100. The substrate transfer apparatus 110 is an example of a substrate transporter (which is a substrate transport structure) according to the present embodiments. Further, the container transfer apparatus 70 is an example of a container transporter (which is a container transport structure) according to the present embodiments.

The container storage shelf 50 (which is used as a second storage configured to store the containers 4) is provided above the sub-housing 40.

As shown in FIGS. 1 and 2, the container storage shelf 50 is an apparatus (structure) configured to store the container 4 (in which a plurality of substrates including the substrate 2 are accommodated) in substrate processing apparatus 10. Hereinafter, the plurality of substrates including the substrate 2 may also be referred to as "substrates 2". For example, the container storage shelf 50 includes: a plurality of shelf plates 54 extending in the four horizontal directions, wherein the containers (for example, 4 containers) 4 can be placed on each of the shelf plates 54; and a second rotator 148 configured to move the shelf plates 54 in a predetermined direction. Hereinafter, each of the shelf plates 54 may also be referred to as a "shelf plate 54". More specifically, the second rotator 148 is a rotator configured to rotate the shelf plate 54 around a rotation shaft extending in the up-down direction. The shelf plate 54 on which the containers 4 are placed can be rotated by the second rotator 148. Thereby, it is possible to place up to four containers 4 on the shelf plate 54.

In other words, the container storage shelf 50 is a transporter provided with a total of one transfer shaft, that is, a transfer shaft configured to rotate around a rotation shaft extending in the up-down direction. Further, the container storage shelf 50 is an example of a shelf according to the present embodiments. Further, the second rotator 148 is an example of a rotation shaft capable of rotating according to the present embodiments.

Further, the shelf plate 54 is rotated intermittently by the second rotator 148 such that the containers 4 placed on the shelf plate 54 are sequentially sent to a front position (front side) facing the buffer shelf 30.

Two substrate loading port structures 60 are provided at the vertical wall 44 of the sub-housing 40 in the up-down direction. The substrate 2 can be transferred (loaded) from the container 4 into the sub-housing 40 or transferred (unloaded) from the sub-housing 40 into the container 4 using the two substrate loading port structures 60. Hereinafter, each of the two substrate loading port structures 60 may also be referred to as a "substrate loading port structure 60". A container opening/closing apparatus 62 is provided at the substrate loading port structure 60. The container opening/closing apparatus 62 is configured to open and close the container 4 by detaching and attaching a lid of the container 4. In addition, a loading/unloading port 64 is provided in the vertical wall 44 corresponding to the substrate loading port structure 60. The substrate 2 can be transferred into or out of the sub-housing 40 through the loading/unloading port 64.

In the substrate processing apparatus main structure 12, the container transfer apparatus 70 capable of transferring the container 4 is provided between the buffer shelf 30 and the container storage shelf 50.

As shown in FIGS. 1 and 2, the container transfer apparatus 70 is an apparatus configured to transfer the container 4 accommodating the substrates 2 in the substrate processing apparatus 10. The container transfer apparatus 70 may include: a mounting table (mounting stage) 86 on which the container 4 is placed; and a fourth linear mover 145, a fifth linear mover 146 and a sixth linear mover 147 configured to move the mounting table 86 in predetermined directions, respectively.

The fourth linear mover 145 is a linear mover configured to linearly move the mounting table 86 in the front-rear direction. The fifth linear mover 146 is connected to the fourth linear mover 145 and is a linear mover configured to linearly move the mounting table 86 in the up-down direction of the fourth linear mover 145. The sixth linear mover 147 is connected to the fifth linear mover 146 and is installed in the substrate processing apparatus main structure 12. The sixth linear mover 147 is a linear mover configured to linearly move the mounting table 86 in the left-right direction of the fourth linear mover 145 and the fifth linear mover 146.

In other words, the container transfer apparatus 70 is a transporter provided with a total of three transfer shafts, that is, a transfer shaft for driving in the front-rear direction, a transfer shaft for driving in the up-down direction, and a transfer shaft for driving in the left-right direction. Further, the container transfer apparatus 70 transfers the container 4 placed on the container storage shelf 50 according to the present embodiments, and places the container 4 on the container storage shelf 50. The fourth linear mover 145 is an example of a vertical shaft capable of moving in the up-down direction according to the present embodiments. Further, the fifth linear mover 146 is an example of a left-right shaft capable of moving in the left-right direction according to the present embodiments.

A heater structure 90 is installed vertically at a rear upper portion of the substrate processing apparatus main structure 12. A process tube 92 constituting a process chamber is arranged in the heater structure 90 in a manner concentric with the heater structure 90. A gas introduction pipe 94 (through which a gas such as a source gas and a purge gas is introduced into the process tube) and an exhaust pipe 96 (through which an inner atmosphere of the process tube 92 is vacuum-exhausted) are connected to the process tube 92.

The support structure transfer apparatus 100 is provided below the heater structure 90 and within the sub-housing 40.

As shown in FIGS. 1 and 2, the support structure transfer apparatus 100 may include: a cap 102 extending horizontally and of an approximately disk shape; a boat 104 provided above the cap 102; and a seventh linear mover 149 configured to move the boat 104 in a predetermined direction.

The cap 102 is configured to close (seal) a lower end opening of the process tube 92 and further configured to support the boat 104 in a state where the boat 104 is provided vertically.

The boat 104 is configured such that the substrates 2 can be accommodated (or supported) in the boat 104 while the substrates 2 are horizontally oriented with their centers aligned with one another in the vertical direction. As the cap 102 is elevated or lowered by the support structure transfer apparatus 100, the boat 104 is loaded into or unloaded from the process tube 92. The boat 104 is configured to hold (support or accommodate) a larger number of the substrates 2 (for example, 150 substrates) as compared with the number of substrates 2 accommodated in the container 4 (for example, 25 substrates).

The seventh linear mover 149 is a linear mover configured to move the boat 104 in the up-down direction. Further, when the cap 102 and the process tube 92 are tightly attached to each other and an inner space of the process tube 92 is sealed, the inner space serves as the process chamber in which the substrate 2 is processed.

In other words, the support structure transfer apparatus 100 is a transporter provided with a transfer shaft for driving in the up-down direction. Further, the support structure transfer apparatus 100 supports the substrate 2 (which is transferred from the container 4 by the substrate transfer apparatus 110 according to the present embodiments) on the boat 104, and transfers the boat 104 supporting the substrate 2 into or out of a process vessel (that is, the process tube 92) by elevating or lowering the cap 102. In addition, the seventh linear mover 149 is an example of a vertical shaft capable of moving in the up-down direction according to the present embodiments.

The substrate transfer apparatus 110 is provided in an inner space of the sub-housing 40. The substrate transfer apparatus 110 is configured to transfer the substrate 2 between the substrate loading port structure 60 and the boat 104.

As shown in FIGS. 1 and 2, the substrate transfer apparatus 110 is an apparatus configured to transfer the substrate 2 into or out of the container 4 and further configured to transfer the substrate 2 to the support structure transfer apparatus 100. The substrate transfer apparatus 110 may include: a base 112 installed in the substrate processing apparatus 10; tweezers 122 configured to grip the substrate 2; and a first linear mover 141, a second linear mover 143, a first rotator 142 and a third linear mover 144 configured to move the tweezers 122 in predetermined directions, respectively. The second linear mover 143 is a linear mover configured to linearly move the tweezers 122 in the up-down direction. The first linear mover 141 is connected to the second linear mover 143 and the first rotator 142, and is a linear mover configured to linearly move the tweezers 122 in the horizontal direction of the second linear mover 143 (in the front-rear direction when the first rotator 142 is at an original position). The first rotator 142 is connected to the first linear mover 141 and the third linear mover 144, and is a rotator configured to rotate the tweezers 122 around a rotation shaft extending in the up-down direction of the first linear mover 141 and the second linear mover 143. The third linear mover 144 is connected to the first rotator 142 and the base 112, and is a linear mover configured to linearly move the tweezers 122 in the up-down direction of the first linear mover 141, the first rotator 142, and the second linear mover 143.

In other words, the substrate transfer apparatus 110 is a transporter provided with a total of four transfer shafts, that is, a transfer shaft for driving in the front-rear direction, two transfer shafts for driving in the up-down direction and a transfer shaft for rotation around a rotation shaft extending in the up-down direction. The first rotator 142 is an example of a rotation shaft capable of rotating according to the present embodiments. Further, the first linear mover 141 is an example of a front-rear shaft capable of moving in the front-rear direction according to the present embodiments. The second linear mover 143 is an example of a vertical shaft capable of moving in the up-down direction according to the present embodiments. The third linear mover 144 is an example of a vertical shaft capable of moving in the up-down direction according to the present embodiments.

In the following description, a configuration among the first linear mover 141 to the seventh linear mover 149, the first rotator 142 and the second rotator 148 may also be simply referred to as a "transfer structure". In other words, "selecting or operating the transfer structure" refers to "selecting or operating the transfer shaft of the transfer structure".

### <Controller>

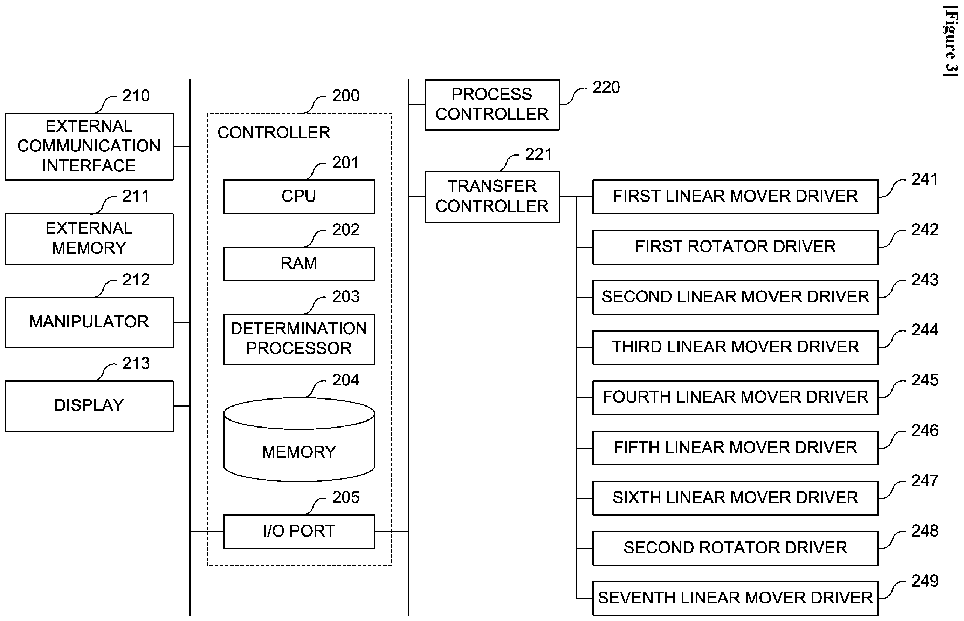

As shown in FIG. 3, the controller 200 may include: a CPU (Central Processing Unit) 201 serving as an example of a processor; and a RAM (Random Access Memory) 202 used as a temporary work area for the CPU 201. Further, the controller 200 functions as a determination processor 203 described later when a control program is executed by the CPU 201. The controller 200 may further include: a memory 204 configured to store the control program (which causes the CPU 201 to function as the controller 200) and an I/O port (input/output port) 205. The CPU 201, the RAM 202, the memory 204 and the I/O port 205 are connected to one another via a bus (not shown).

In a manner described above, a dedicated processor and a memory configured to execute each process are assigned to the controller 200. The CPU 201 is configured to read the control program from the memory 204 and further configured to execute an overall control of the substrate processing apparatus 10 under a control of the controller 200. That is, the controller 200 according to the present embodiments is an example of a computer.

The memory 204 is an example of a storage apparatus capable of maintaining information stored therein even when the power supplied thereto is cut off. For example, a semiconductor memory may be used as the memory 204. However, a hard disk may also be used as the memory 204.

Further, as shown in FIG. 3, the I/O port 205 is connected to a process controller 220 and a transfer controller 221.

The process controller 220 is a control apparatus configured to control the substrate processing apparatus 10 to execute a processing procedure for the substrate 2. Specifically, the process controller 220 is connected to apparatuses such as a temperature measuring apparatus (not shown), a pressure measuring apparatus (not shown) and a gas control apparatus (not shown) configured to control a supply of a gas such as a process gas and an inert gas used to process the substrate 2.

As shown in FIG. 3, the transfer controller 221 is a control apparatus to which a total of nine drivers are connected, namely, a first linear mover driver 241, a second linear mover driver 243, a third linear mover driver 244, a fourth linear mover driver 245, a fifth linear mover driver 246, a sixth linear mover driver 247, a seventh linear mover driver 249, a first rotator driver 242 and a second rotator driver 248.

In the present embodiments, the term "linear mover driver" refers to a control apparatus configured to control the transfer structure when the transporter moves in a specific direction. For example, the first linear mover driver 241 to the seventh linear mover driver 249 correspond to the first linear mover 141 to the seventh linear mover 149, respectively. For example, the first linear mover driver 241 shown in FIG. 3 drives the first linear mover 141 configured to move the tweezers shown in FIGS. 1 and 2 in the front-rear direction when instructed by the controller 200. The same also applies to the other linear mover drivers and the rotators mentioned above.

As shown in FIG. 3, an external communication interface 210, an external memory 211, the manipulator 212 and the display 213 are connected to the I/O port 205.

The external communication interface 210 is connected to a communication line and provided with a communication protocol for transmitting and receiving data to and from an external apparatus (not shown) connected to the same communication line. The external communication interface 210 performs data communication with the external apparatus in accordance with an instruction from the CPU 201 in the controller 200.

The external memory 211 is an apparatus capable of storing various data and the like, and is provided separately from the memory 204 of the controller 200. A specific configuration of the external memory 211 is not particularly limited. However, for example, a storage apparatus such as a network attached storage (NAS) connected via a network or a portable recording medium such as an SD memory card may be used as the external memory 211.

The manipulator 212 is an apparatus configured to receive an instruction from the operator and further configured to notify the CPU 201 (of the controller 200) of the instruction received in a manner described above. For example, a button provided on a housing of the substrate processing apparatus 10 or an operation pendant connected to the substrate processing apparatus 10 may be used as the manipulator 212. The display 213 is an apparatus configured to display information about the substrate processing apparatus 10. For example, a configuration such as a liquid crystal display and an organic EL (Electro Luminescence) display may be used as the display 213.

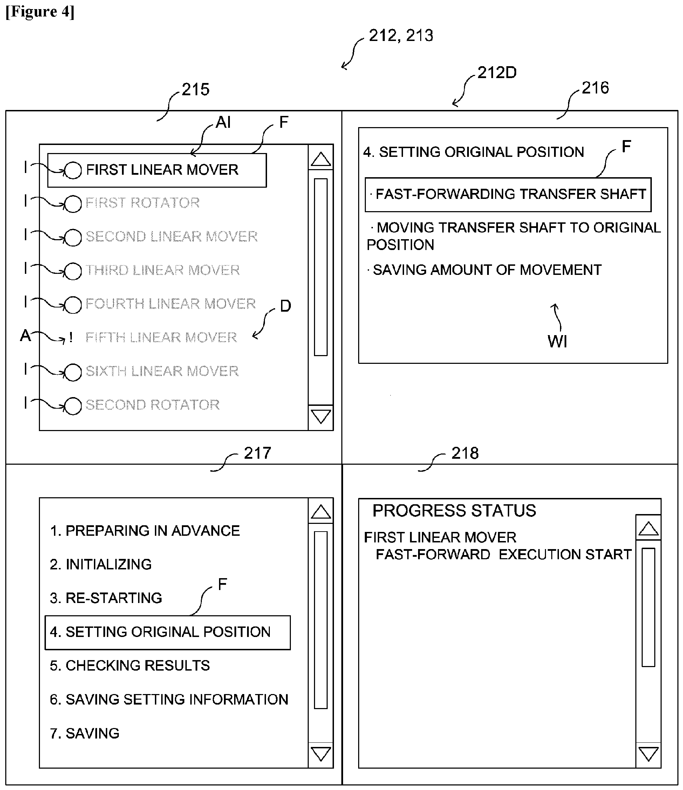

The manipulator 212 and the display 213 of the present embodiments will be described by way of an example in which a touch panel capable of being operated by touching a screen thereof by the operator, as shown in FIG. 4 described later, is used. In other words, the touch panel of the present embodiments is an apparatus configured to serve as both of the display 213 and the manipulator 212. Contents displayed on the touch panel will be described in detail later.

Further, each configuration connected to the I/O port 205 is merely an example, and a configuration corresponding to the function of the substrate processing apparatus 10 is connected the I/O port 205. The configuration corresponding to the function of the substrate processing apparatus 10 may refer to an execution configuration configured to execute a processing under a control of a processor such as the CPU 201 and the RAM 202.

### <Display>

As shown in FIG. 4, a transfer shaft selection area 215, a start-up procedure display area 217, a work procedure display area 216 and a progress status display area 218 are displayed on the screen of the display 213.

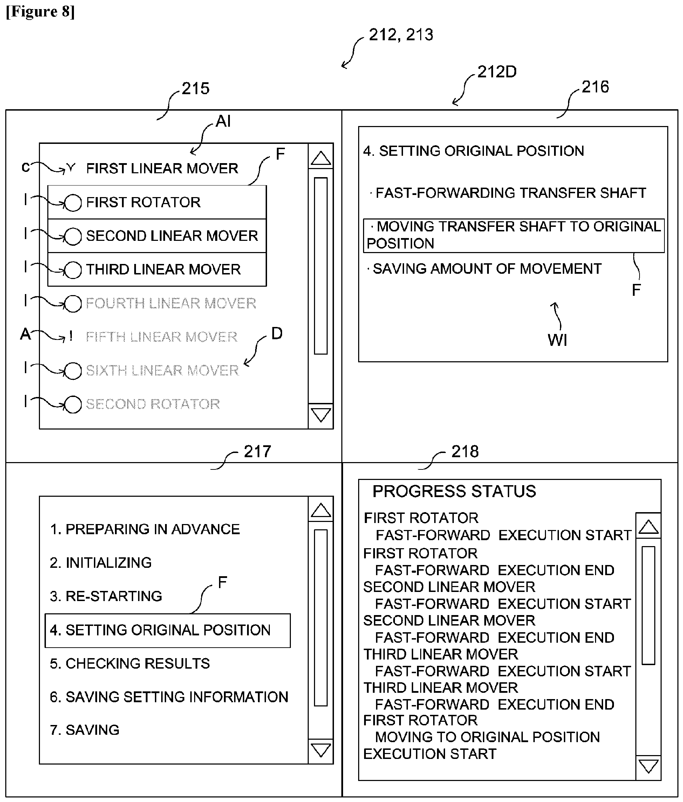

As shown in FIG. 4 and FIG. 8 described later, items "Al" of the transfer structures of the substrate processing apparatus 10 are displayed in the transfer shaft selection area 215. Hereinafter, each of the items AI may also be referred to as an "item AI". More specifically, in the transfer shaft selection area 215, names of the transfer structures of the substrate processing apparatus 10 are aligned vertically as an example of the items AI. Further, the items AI of the transfer structures displayed in the transfer shaft selection area 215 can be selected by the operator using the touch panel. Further, the controller 200 distinguishes an item AI (which is selected by the operator) from the other items AI (which are not selected by the operator) by surrounding the item with a frame F. Further, the item AI is also marked with a mark indicating a state of the transfer structure related thereto. In other words, the controller 200 switches a displayed image of the item AI (which is selected) by adding the frame F to the item AI (which is selected). The frame F is a display for distinguishing the item AI (which is selected) from the other items AI (which are not selected). For example, a border of the frame F may be displayed. Instead of displaying the border of the frame F, a background of an area indicated by the frame F, that is, an area corresponding to the item AI (which is selected) may be displayed differently from the other items AI (which are not selected).

For example, as shown in FIG. 4 and FIG. 8 described later, when a calibration is performed for the transfer structure and a distance from the transfer structure to the original position in the mechanical coordinates of the substrate processing apparatus 10 is known, the transfer structure is marked with a mark "C", indicating a state in which a position setting is complete. However, when the calibration is not performed for the transfer structure and the distance from the transfer structure to the original position in the mechanical coordinates of the substrate processing apparatus 10 is unknown, the transfer structure is marked with a mark "I", indicating a state in which a position setting is incomplete. Further, when the substrate processing apparatus 10 is being assembled and the transfer structure has not been installed in the substrate processing apparatus 10, in other words, when the line is not connected therebetween, the transfer structure is marked with a mark "A", indicating a state in which the line is disconnected.

Further, according to the present embodiments, when the transfer structure cannot be selected for a reason described later, the item AI representing the transfer structure (which cannot be selected) is displayed lightly as an unselectable display "D", thereby indicating that the transfer structure cannot be selected. For example, in FIG. 4, the transfer structures other than the first linear mover 141 are displayed lightly as the unselectable display D.

Further, according to the present embodiments, when the operator calibrates the transfer structure, there may be a case where the operator can select a plurality of transfer structures together. The case where the operator can select the plurality of transfer structures together and the display of the transfer shaft selection area 215 in such a case will be described later.

In the start-up procedure display area 217, a list of procedures from a procedure of preparing in advance for the calibration of the transfer shaft selected in the transfer shaft selection area 215 to a procedure of saving information on an initial position when the calibration is completed. In addition, as shown in FIG. 4 and FIG. 8 described later, among the list of procedures, a procedure being executed is displayed with the frame F attached thereto.

In the work procedure display area 216, a work procedure (which is processing contents of the procedure displayed by the frame F in the start start-up procedure display area 217 for the transfer structure selected by the operator in the transfer shaft selection area 215) is displayed as a work item "WI". In other words, the controller 200 switches a displayed image of the work item WI (which represents a work being performed) to a different display from the other work items WI by adding the frame F to the work item AI. In other words, the controller 200 switches the displayed image of the work procedure in accordance with the work being performed by adding the frame F to the work item WI.

In the progress status display area 218, operations to be performed during a calibration work shown in the work procedure display area 216 for the transfer structure selected by the operator in the transfer shaft selection area 215 are displayed. More specifically, in the progress status display area 218, contents of a work (which is started by the controller 200 to be performed on the transfer structure) among the procedures of the calibration work and the work that has been completed are displayed. For example, in an example of FIG. 8, "FAST FORWARD EXECUTION START" and "FAST FORWARD EXECUTION END" are displayed for each transfer shaft, indicating that the execution of operations shown in the work procedure display area 216 has started and ended for the first rotator 142, the second linear mover 143 and the third linear mover 144, respectively. In addition, in the example of FIG. 8, since the work for the first rotator 142 is further progressing, "MOVING TO ORIGINAL POSITION EXECUTION START" is also displayed. Further, when the work is not completed normally due to an occurrence of an error, a timeout or other reasons, a message indicating that the work has ended abnormally may be further displayed.

When the procedure executed by the controller 200 moves on, new items are added and displayed in the progress status display area 218. In other words, the controller 200 adds and displays the new items, thereby switching a displayed image of the progress status display area 218 to show a work progress status in accordance with the work being performed.

Subsequently, operations of the substrate processing apparatus 10 will be described.

### <Transfer Operation>

When the container 4 is placed on the mounting table 20 at the loading/unloading position, the mounting table 20 is moved to the transfer position by the transfer structure 22. Accordingly, the container 4 is loaded into the substrate processing apparatus main structure 12 through the loading/unloading port 16.

The container 4 loaded into the substrate processing apparatus main structure 12 is transferred by the container transfer apparatus 70 from the mounting table 20 to a predetermined position on the buffer shelf 30 or the container storage shelf 50, where the container 4 is temporarily stored. The container 4 stored on the buffer shelf 30 or the container storage shelf 50 is transferred by the container transfer apparatus 70 to a predetermined substrate loading port structure (that is, one of an upper and lower substrate loading port structures) 60 among the two substrate loading port structures 60. Hereinafter, the predetermined substrate loading port structure 60 may also be simply referred to as the "substrate loading port structure 60". Alternatively, the container 4 may be transferred directly from the mounting table 20 to the substrate loading port structure 60.

The lid of the container 4 transferred into the substrate loading port structure 60 is opened by the container opening/closing apparatus 62. In parallel with opening the lid of the container 4, another container 4 is transferred to the other substrate loading port structure 60 (that is, the other one of the upper and lower substrate loading port structures).

For example, when an operation of opening the lid of the container 4 is being performed at the upper substrate loading port structure 60 while the another container 4 is being transferred to the lower substrate loading port structure 60, it is possible to reduce a waiting time (stand-by time) for replacing the containers 4 as compared with a case where such a configuration is not provided.

When the lid of the container 4 is opened at the substrate loading port structure 60, the substrates 2 accommodated in the container 4 are transferred (loaded) into the boat 104 by the substrate transfer apparatus 110.

### <Processing Operation>

The containers 4 are repeatedly supplied to the substrate loading port structure 60. In a state where the substrates 2 accommodated in the containers 4 are held (supported) in the boat 104, the substrates 2 are batch-processed.

After a predetermined number of substrates 2 are held in the boat 104, the boat 104 is elevated by the support structure transfer apparatus 100 and loaded into the process tube 92. After the boat 104 is loaded, the cap 102 supporting the boat 104 closes the lower end opening of the process tube 92 so as to airtightly close an inside of the process tube 92.

When the process chamber of the process tube 92 is airtightly closed, the inner atmosphere of the process tube 92 is vacuum-exhausted to a predetermined vacuum level through the exhaust pipe 96, and the process tube 92 is heated to a predetermined temperature by the heater structure 90. Then, a predetermined source gas is supplied at a predetermined flow rate through the gas introduction pipe 94. In a manner described above, a predetermined process (for example, a process of forming a film such as a CVD film) is performed on the substrate 2.

After a predetermined process time has elapsed, the boat 104 is lowered by the support structure transfer apparatus 100, and the boat 104 is transferred to a standby position. In parallel with the processing operation of loading/unloading the boat 104 into/from the process tube 92 and processing the substrate 2, the container transfer apparatus 70 transfers the containers 4. Further, in the present specification, the "process time" refers to a time (time duration) during which the process related thereto is performed. The same also applies to the following descriptions.

The substrates 2 (which are processed and held in the boat 104) are transferred (unloaded) by the substrate transfer apparatus 110 into the container 4 waiting at the substrate loading port structure 60. Then, the lid of the container 4 is closed by the container opening/closing apparatus 62.

The container 4 accommodating the substrates 2 (which are processed) is then transferred by the container transfer apparatus 70 to the buffer shelf 30 or the container storage shelf 50.

A transfer operation for the substrates 2 (which are processed) is performed such that the containers 4 are repeatedly supplied to the substrate loading port structure 60 and the substrates 2 (which are processed) are accommodated from the boat 104 into the containers 4.

For example, by transferring the substrates 2 from the boat 104 to one of the upper substrate loading port structure 60 and the lower substrate loading port structure 60 while another container 4 is being transferred to the other one of the upper substrate loading port structure 60 and the lower substrate loading port structure 60, it is possible to reduce the waiting time (stand-by time) for replacing the containers 4 as compared with a case where such a configuration is not provided.

The container 4 accommodating the substrates 2 (which are processed) is transferred from the buffer shelf 30 or the container storage shelf 50 to the mounting table 20 located at the transfer position by the container transfer apparatus 70. Subsequently, the mounting table 20 is transferred to the loading/unloading position by the transfer structure 22, and the container 4 is unloaded from the substrate processing apparatus main structure 12. Alternatively, the container 4 accommodating the substrates 2 (which are processed) may be transferred directly from the substrate loading port structure 60 to the mounting table 20.

Such operations described above are performed in accordance with procedures prescribed (or defined) by the program executed by the CPU 201 described above.

### <Calibration Work>

On the other hand, the operator or a user who uses the substrate processing apparatus 10 may perform the calibration work to determine an amount of movement of the transfer structure with respect to the transporter (such as the substrate transfer apparatus 110, the container transfer apparatus 70, the container storage shelf 50 and the support structure transfer apparatus 100) included in the substrate processing apparatus 10. Specifically, in order to transfer the transfer object normally, the original position of each transfer structure is recognized such that the controller 200 can recognize the actual position of the transfer object. According to the present embodiments, the original position of each transfer structure is an example of the initial position in the present embodiments, and an operation of causing the controller 200 to recognize the original position of each transfer structure is an example of an initial position setting.

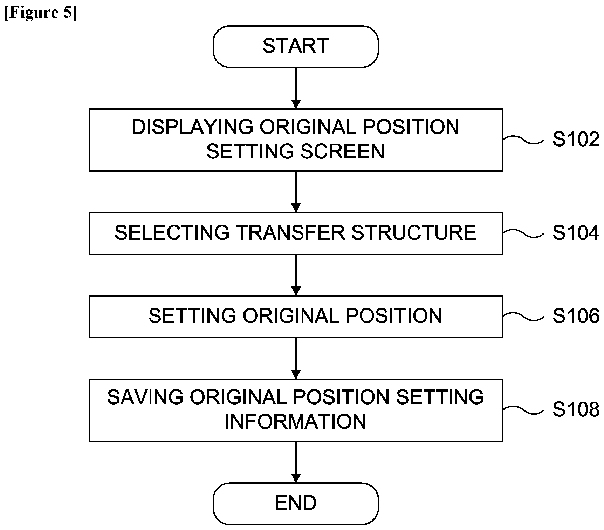

Subsequently, procedures of the calibration work for each transfer structure according to the present embodiments will be described with reference to FIG. 5.

### <Procedures of Calibration Work>

First, the CPU 201 reads out the program from the memory 204 and starts executing the procedures of the calibration work. Then, the CPU 201 proceeds to a step S102.

In the step S102, the CPU 201, in accordance with the program, displays an original position setting screen on the screen of the touch panel as shown in FIG. 4. Then, the CPU 201 proceeds to a step S104.

Subsequently, in the step S104, the CPU 201 waits for the operator to select the transfer structure (that is, a specified transfer structure). More specifically, the CPU 201 waits for the operator to select the specified transfer structure among the transfer structures displayed in the transfer shaft selection area 215. When the operator selects the specified transfer structure among the transfer structures, the CPU 201 displays procedures of the original position setting for the specified transfer structure (selected transfer structure) in the work procedure display area 216. In other words, a procedure in the step S104 is an example of a selection step in which the manipulator 212 is used to select a specified transporter among the transporters configured to transfer the substrate 2 or the container 4 accommodating the substrates 2. Then, the CPU 201 proceeds to a step S106.

Subsequently, in the step S106, the CPU 201 sets the original position. More specifically, the CPU 201 waits for an execution instruction to be input by the operator to execute the procedure displayed in the work procedure display area 216. When the execution instruction is input, the CPU 201 moves the transfer object of the specified transfer structure to the original position thereof in accordance with the program. For example, in FIG. 4, the CPU 201 fast-forwards the tweezers 122 with respect to the first linear mover 141 until the tweezers 122 are located at the original position original position. Then, when it is confirmed that the specified transfer structure (that is, the tweezers 122 of the first linear mover 141 in FIG. 4) is located at the original position, the CPU 201 proceeds to a step S108.

Subsequently, in the step S108, the CPU 201 stores information that the specified transfer structure has moved to its original position and that its calibration has been completed in the memory 204, as original position setting information. More specifically, the CPU 201 stores, in the memory 204, information that the specified transfer structure has moved to its original position and its deviation from the original position of the mechanical coordinates.

That is, the procedures from the step S106 to the step S108 are an example of a setting step of performing an initial setting for the specified transfer structure by using the manipulator 212. Then, after completing the step S108, the CPU 201 ends the procedures of the calibration work. While the first linear mover 141 is described as an example in the above description, the same applies to the other transfer structures (the second linear mover 143 to the seventh linear mover 149, the first rotator 142 and the second rotator 148).

Further, a case where the specified transfer structure (selected transfer structure) moves to its original position and the calibration work is completed is an example of a case where the initial position setting according to the present embodiments is normally completed.

However, some of the transfer structures included in the substrate processing apparatus 10 may be provided with a period (time duration) during which the calibration work mentioned above should not be performed.

Specifically, according to the present embodiments, , when the second linear mover 143, the third linear mover 144 or the first rotator 142 is driven in a state where the first linear mover 141 is not in its original position, the tweezers 122 may collide with another configuration such as the substrate transfer apparatus 110 and thereby be damaged. In such a case, the operator can calibrate the second linear mover 143, the third linear mover 144 and the first rotator 142 after calibrating the first linear mover 141 by moving the first linear mover 141 to its original position.

In addition, for example, in order to check whether each transfer structure is operating normally during the assembly of the substrate processing apparatus 10, a single transfer structure alone may be operated on trial in a state where the single transfer structure is assembled alone without installing the entire drive shafts.

In such a case, it is preferable that the transfer structure which can be operated by the operator is limited to a predetermined transfer structure. For example, according to the present embodiments, the determination processor 203 configured by the program executed by the CPU 201 of the controller 200 determines that the calibration work can be performed on another transfer structure when the operator has completed the calibration work on the first linear mover 141. On the other hand, the determination processor 203 determines that the calibration work cannot be performed on another transfer structure when the operator has not completed the calibration work on the first linear mover 141. The first linear mover 141 may be regarded as the predetermined transfer structure in the present embodiments.

However, when the operator is an experienced technician, the procedures of the calibration work may be performed by simultaneously operating a plurality of transfer structures and simultaneously setting the original position of each of the plurality of transfer structures. Thereby, it is possible to shorten a work time.

In such a case, it is not preferable that the transfer structure which can be operated by the operator is limited to the predetermined transfer structure and that the operator is forced to calibrate the transfer structures one by one.

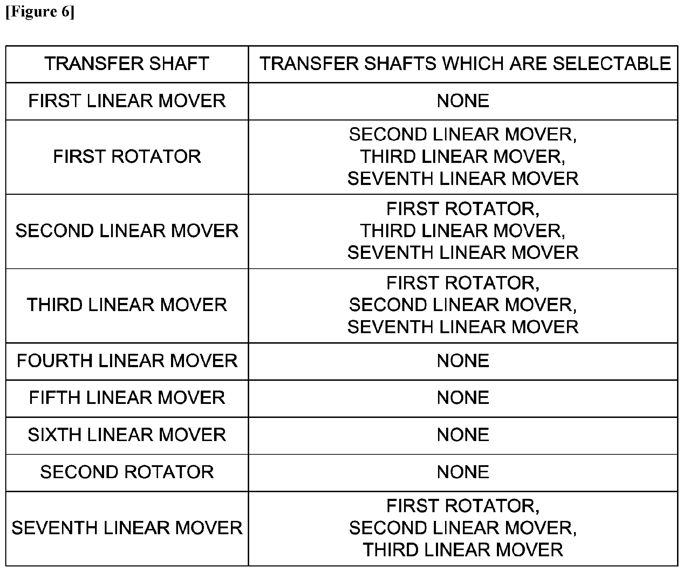

Subsequently, operations of the controller 200 in the substrate processing apparatus 10 according to the present embodiments will be described with reference to FIGS. 6 to 8.

### <Initial Position Setting Work According To Present Embodiments>

FIG. 6 is a diagram schematically illustrating a correspondence table stored in the memory 204 according to the present embodiments. The correspondence table indicates transfer structures selectable at the same time. More specifically, when the operator selects a specified transfer structure among the transfer structures listed in the left column shown in FIG. 6, the CPU 201 set transfer structures other than those in the right column to be non-selectable. For example, in FIG. 6, when the first rotator 142 is selected as the specified transfer structure, transfer structures other than the second linear mover 143, the third linear mover 144 and the seventh linear mover 149 are set to be non-selectable. In addition, for example, in FIG. 6, when the first linear mover 141 is selected as the specified transfer structure, all the other transfer structures are set to be non-selectable. That is, according to the present embodiments, the correspondence table shown in FIG. 6 is an example of predefined parameters in the present embodiments.

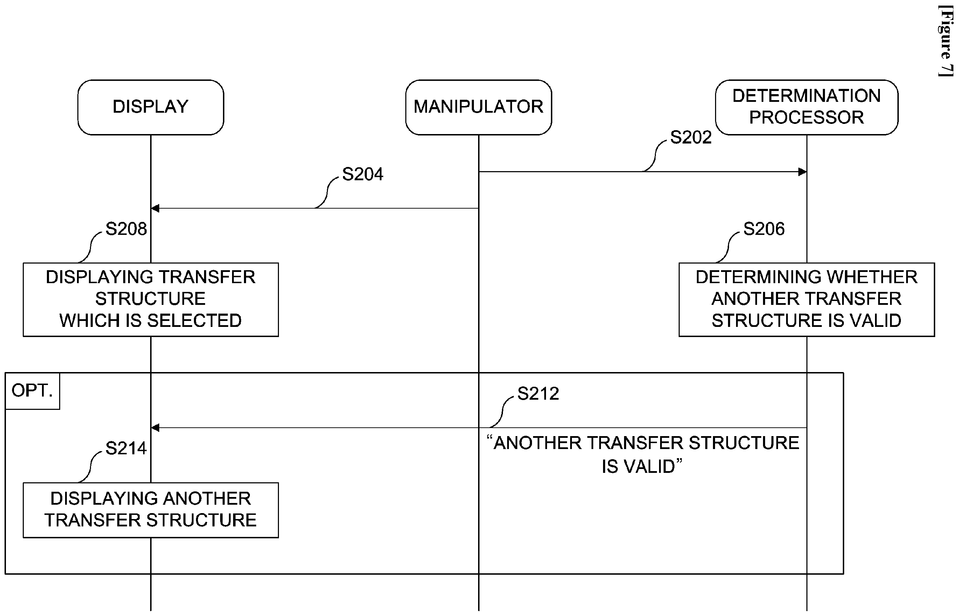

More specifically, by executing the program, the CPU 201 switches the displayed image on the display 213 together with another configuration to notify whether or not another transfer structure can be selected. The procedures executed by the controller 200 will be described with reference to FIG. 7.

First, as shown in FIG. 7, when the operator selects a specified transfer structure among the transfer structures displayed in the transfer shaft selection area 215, the manipulator 212 notifies the determination processor 203 of the specified transfer structure (selected transfer structure) in a sequence S202. In a sequence S204, the manipulator 212 also notifies the display 213 of the specified transfer structure.

Subsequently, in a sequence S206, the determination processor 203 determines, based on the correspondence table, whether or not there is a transfer structure (or there are transfer structures) that can be selected simultaneously with the specified transfer structure. In other words, in the sequence S206, the determination processor 203 determines whether or not another transfer structure is valid (that is, selectable). That is, a procedure of the sequence S206 is an example of a determination step of determining whether the initial position setting for the specified transfer structure (that is, the transfer structure selected by the manipulator 212 in the present embodiments) has been completed and determining whether or not the initial position setting for another transfer structure can be performed in parallel with the initial position setting for the specified transfer structure.

In addition, in a sequence S208, the display 213 displays the specified transfer structure by adding the frame F to the specified transfer structure selected among the transfer structures displayed in the transfer shaft selection area 215.

Further, when it is determined in the sequence S206 that there is a transfer structure (or there are the transfer structures) that can be selected simultaneously with the specified transfer structure, in a sequence S212, the determination processor 203 transmits a determination result in the sequence S206 to the display 213. That is, a procedure of the sequence S212 is an example of a step of notifying the determination result in the determination step in the present embodiments.

Then, in a sequence S214, the display 213 displays that the other transfer structures (except for the transfer structures which are selectable and whose information was transmitted in the sequence S212 from the determination processor unit 203) are unselectable. More specifically, in the sequence S214, the display 213 lightly displays the other transfer structures (except for the transfer structures which are selectable) as the unselectable display D, as shown in the transfer shaft selection area 215 in FIG. 8.

Further, when the determination processor 203 determines, in the sequence S206, that another transfer structure is not valid (that is, unselectable), the sequence S212 is not executed. In other words, when the sequence S212 is not executed, the other transfer structures (except for the transfer structures which are selectable) are displayed lightly. In other words, even when the determination processor 203 does not execute the sequence S212 and does not transmit the information on other transfer structures (which are selectable) to the display 213, such an operation is another example of a process for notifying the determination result in the determination process in this embodiment.

The controller 200 according to the present embodiments performs the calibration for the plurality of transporters provided with the plurality of transfer structures by executing a series of procedures mentioned above with the CPU 201. Further, the series of procedures mentioned above can be executed for any of the transfer structures of the substrate processing apparatus 10. Therefore it can be regarded that the entire transfer structures are initially set by the series of procedures mentioned above.

### <Processing Step>

In the substrate processing apparatus 10 according to the present embodiments, the substrate 2 is processed using the transporter whose transfer structure has been calibrated by the calibration work mentioned above. More specifically, after completing the calibration work for the entirety of the transfer structures, the information is input into the manipulator 212 by the operator. Then, the transfer operation and the processing operation mentioned above are performed by the controller 200 to process the substrate 2 and to manufacture a semiconductor device.

According to the present embodiments, it is possible to obtain one or more of the following effects.

### <Functions and Effects>

Before starting up the substrate processing apparatus 10, the initial position setting for each of the transfer structures of each transporter is completed. For example, when the procedure of the initial position setting for each of the transfer structures of each transporter is incorrect, the substrate processing apparatus 10 may not operate normally.

However, according to the substrate processing apparatus 10 of the present embodiments, it is possible to reduce the burden on the operator because the operator can select, by the manipulator 212, one or more transfer structures for which the initial position can be set by looking at the transfer structures displayed on the display 213. Thus, even when the operator mistakenly selects the specified transfer structure for which the initial position can be set, the determination processor 203 determines whether the initial position setting for the specified transfer structure (selected transfer structure) is valid or invalid, and the controller 200 selectively controls the drive shaft determined to be valid to perform the initial position setting for the transfer structure. When the initial position setting for the specified transfer structure is invalid, since the controller 200 notifies the operator that the initial position setting for the specified transfer structure is invalid, it is possible to prevent inconvenience caused by the initial position setting operation related thereto.

Further, according to the substrate processing apparatus 10 of the present embodiments, by checking whether the initial position of the predetermined transfer structure is set before operating another transfer structure, it is possible to avoid collisions between the transporters and it is also possible to improve a work safety.

Furthermore, in the substrate processing apparatus 10 according to the present embodiments, since the parameters of other shafts (which are selectable) that can be selected together with the selected shaft related to the specified transfer structure are set, it is possible to easily check one or more selectable shafts that can be selected together with the selected shaft by referring to the parameters. Further, since the parameters are editable, it is possible to set the selectable shafts depending on an apparatus configuration.

Each transporter is provided with various transfer apparatuses, and each transfer apparatus is provided with a plurality of transfer structures.

For example, according to the substrate processing apparatus 10 of the present embodiments, the initial settings for each shaft of various transfer apparatuses can be displayed together. Thereby, it is possible to set the initial position of each drive shaft in parallel. Further, it is possible to reduce the burden on the operator and it is also possible to prevent the settings of the drive shafts from being omitted.

Further, according to the substrate processing apparatus 10 of the present embodiments, each transporter is provided with a plurality of transfer structures, and the display 213 can be used to set the initial positions of the plurality of transfer structures. Thereby, it is possible to reduce the burden on the operator and it is also possible to prevent the settings from being missed.

Further, according to the substrate processing apparatus 10 of the present embodiments, it is possible to select a plurality of transfer structures for which the initial position setting can be performed. Thereby, it is possible to contribute to improving the work efficiency when setting up the apparatus.

Further, according to the substrate processing apparatus 10 of the present embodiments, when a specific shaft is selected, it is possible to select another shaft which can be set in parallel with the specific shaft by referring to the parameters. Then, by selecting a plurality of other shafts, each shaft selected in manner described above can be changed and the initial setting can be performed.

Therefore, according to the substrate processing apparatus 10 of the present embodiments, by setting the initial positions of the plurality of shafts in parallel, it is possible to contribute to reducing the number of steps for the initial setting for the shafts.

In the present embodiments, the initial position setting is also performed on the substrate transfer apparatus 110 serving as the transporter. According to the substrate processing apparatus 10 of the present embodiments, the initial position setting for the substrate transfer apparatus 110 can be performed in parallel with that of another transfer structure. Thereby, it is possible to contribute to improving the work efficiency when setting up the apparatus. Further, the initial position setting for a plurality of transfer structures is performed within a range where the safety can be confirmed by the determination processor 203. Therefore, it is possible to avoid problems such as collisions between the transfer structures.

In the present embodiments, the initial position setting is also performed on the container transfer apparatus 70 serving as the transporter. According to the substrate processing apparatus 10 of the present embodiments, the initial position setting for the container transfer apparatus 70 can be performed in parallel with that of another transfer structure. Thereby, it is possible to contribute to improving the work efficiency when setting up the apparatus. Further, the initial position setting for a plurality of transfer structures is performed within a range where the safety can be confirmed by the determination processor 203. Therefore, it is possible to avoid the problems such as the collisions between the transfer structures.

Further, according to the substrate processing apparatus 10 of the present embodiments, it is possible to clarify the transfer structure. Thereby, it is possible for the operator to easily check the transfer structure.

Further, according to the substrate processing apparatus 10 of the present embodiments, by selecting the transfer structure, it is possible for the operator to easily perform the initial position setting for the transfer structure.

Further, according to the substrate processing apparatus 10 of the present embodiments, it is possible to clarify the transfer structure (which is selected). Thereby, it is possible to easily check the transfer structure (which is selected).

Further, according to the substrate processing apparatus 10 of the present embodiments, by displaying the work procedure in the work procedure display area 216, it is possible to clarify a flow of the work. Further, even an inexperienced operator can check the work.

Further, according to the substrate processing apparatus 10 of the present embodiments, by clarifying the work being performed, it is possible for the operator to easily check the work. Further, even the inexperienced operator can check the work.

Further, according to the substrate processing apparatus 10 of the present embodiments, by displaying detailed information about the work being performed, it is possible to clarify a detailed flow of the work. In addition, according to the substrate processing apparatus 10 of the present embodiments, even when a plurality of transfer structures are selected, it is possible to easily check the status of each transfer structure.

Further, according to the substrate processing apparatus 10 of the present embodiments, by checking the status of each transfer structure, it is possible to easily clarify the transfer structure for which the initial position setting is performed.

Further, according to the substrate processing apparatus 10 of the present embodiments, by clarifying the transfer structure for which the initial position setting cannot be performed, it is possible to contribute to reducing an erroneous work.

Further, according to the substrate processing apparatus 10 of the present embodiments, by storing the setting information (that is, the original position setting information) of the transfer structure (which has been normally terminated) in the memory 204, it is also possible to prevent the operator from forgetting to save the setting information when the transfer structure is normally terminated.

For example, a method of manufacturing a semiconductor device according to the present embodiments may include: (a) selecting, by using the manipulator 212, a specified transporter from a plurality of transporters provided with one or more transfer structures and configured to transfer the substrate 2 or the container 4 accommodating the substrate 2; (b) performing the initial position setting for a specified transfer structure in the specified transporter by using the manipulator 212; (c) determining whether or not the initial position setting for the specified transfer structure selected by the manipulator 212 is completed and whether or not it is possible for the initial position setting for another transfer structure to be performed in parallel with that of the specified transfer structure; (d) notifying the determination result in (c); and (e) transferring the substrate 2 by the specified transporter selected in (a) and processing the substrate 2.

According to the method of manufacturing the semiconductor device of the present embodiments, it is possible to suppress a decrease in the work efficiency in the initial position setting operation for the substrate processing apparatus 10.

For example, a program according to the present embodiments may cause the controller 200 of the substrate processing apparatus 10 to perform: (a) selecting, by using the manipulator 212, a specified transporter from a plurality of transporters provided with one or more transfer structures and configured to transfer the substrate 2 or the container 4 accommodating the substrate 2; (b) performing the initial position setting for a specified transfer structure in the specified transporter by using the manipulator 212; (c) determining whether or not the initial position setting for the specified transfer structure selected by the manipulator 212 is completed and whether or not it is possible for the initial position setting for another transfer structure to be performed in parallel with that of the specified transfer structure; (d) notifying the determination result in (c); and (e) transferring the substrate 2 by the specified transporter selected in (a) and processing the substrate 2.

According to the program of the present embodiments, it is possible to suppress the decrease in the work efficiency in the initial position setting operation for the substrate processing apparatus 10.

<Modified Examples>

For example, in the above description, it is considered that the determination processor 203 determines whether or not the initial position setting for another transfer structure can be performed based on whether or not the initial position setting for the predetermined transfer structure has been completed. However, the technique of the present disclosure is not limited thereto. For example, the determination processor 203 may determine whether or not the initial position setting has been completed based on an input to the manipulator 212 by the operator.

For example, in the above description, the determination processor 203 determines whether or not the initial position setting for another transfer structure can be performed based on the predefined parameters and the state of the specified transfer structure (which is selected). However, the technique of the present disclosure is not limited thereto. For example, the determination processor 203 may determine whether or not the initial position setting has been completed based on the input to the manipulator 212 by the operator.

For example, in the above description, the plurality of transporters include the substrate transfer apparatus 110, the container transfer apparatus 70, the container storage shelf 50 and the support structure transfer apparatus 100. However, the technique of the present disclosure is not limited thereto. For example, the substrate processing apparatus 10 may not include one of the transporters exemplified above as long as the substrate 2 can be transferred.

For example, in the above description, the manipulator 212 can select a plurality of transfer structures. However, the technique of the present disclosure is not limited thereto. For example, the manipulator 212 may accept a selection of a single transfer structure at a time.

For example, in the above description, the controller 200 can control the initial position setting operations for the transfer structures (which are selected) to be performed in parallel. However, the technique of the present disclosure is not limited thereto. For example, the controller 200 may perform the initial position setting operations for the transfer structures (which are selected) in order (sequentially) for each transfer structure, rather than in parallel.

For example, in the above description, the transporters include the substrate transporter configured to transfer the substrate 2. However, the technique of the present disclosure is not limited thereto. For example, the transporters may not include the substrate transporter.

For example, in the above description, the transporters include the container transporter configured to transfer the container 4. However, the technique of the present disclosure is not limited thereto. For example, the transporters may not include the container transporter.

For example, in the above description, the display 213 is provided with the transfer shaft selection area 215 in which the plurality of items AI can be aligned and displayed. However, the technique of the present disclosure is not limited thereto. For example, the display 213 may be constituted by a plurality of lamps, and the transporters may correspond to the lamps, respectively.

For example, in the above description, the display 213 displays the item AI of the transfer structure. However, the technique of the present disclosure is not limited thereto. For example, the display 213 may not be provided with a screen display, and the transfer structure may be indicated by a lamp which is turned on or off.

For example, in the above description, when the item AI is operated, the transfer structure corresponding to the item AI is selected. However, the technique of the present disclosure is not limited thereto. For example, the display 213 and the manipulator 212 may be provided separately, and the transfer structure may not be selected even when the item AI on the display 213 is operated.

For example, in the above description, the controller 200 controls the display 213 such that the item AI of the transfer structure (which is selected) is displayed differently from the item AI of another transfer structure (which is not selected). However, the technique of the present disclosure is not limited thereto. For example, the controller 200 may control the display of the transfer structure (which is selected) and the display of the item AI of another transfer structure (which is not selected) in a same manner.

For example, in the above description, the controller 200 aligns and displays the work items WI indicating the work procedure for the initial position setting for the transfer structure (which is selected in the transfer shaft selection area 215) in the work procedure display area 216. However, the technique of the present disclosure is not limited thereto. For example, the controller 200 may not display the work items WI indicating the work procedure for the initial position setting for the transfer structure in the work procedure display area 216. Further, the controller 200 may also display the work items WI of the entirety of transfer structures in the work procedure display area 216 without being limited to the transfer structure (which is selected).

For example, in the above description, in accordance with the work being performed, the controller 200 switches the displayed image of the work item WI (which represents the work being performed) displayed in the work procedure display area 216 to a different display from the other work items WI. However, the technique of the present disclosure is not limited thereto. For example, the controller 200 may control the display of the work item WI of the transfer structure (which is selected) and the display of the work item WI of another transfer structure (which is not selected) in a same manner.

For example, in the above description, the controller 200 switches and shows the work progress status in accordance with the work being performed. However, the technique of the present disclosure is not limited thereto. For example, the controller 200 may not display the work progress status on the screen.

For example, in the above description, the display 213 can display the state in which the line is disconnected, the state in which the position setting is incomplete and the state in which the position setting is complete. However, the technique of the present disclosure is not limited thereto. For example, the display 213 may not display one or more among the state in which the line is disconnected, the state in which the position setting is incomplete and the state in which the position setting is complete. Further, for example, the entire states exemplified above may not be displayed.

For example, in the above description, when the line of any one of the transfer structures is disconnected, the controller 200 set the transfer structure whose line is disconnected to be unselectable. However, the technique of the present disclosure is not limited thereto. For example, even when the line of the transfer structure is disconnected, the controller 200 may set the transfer structure whose line is disconnected to be selectable without switching the image on the screen display.

For example, in the above description, the manipulator 212 is configured to be controlled to store the information about the initial position in the memory 204 when the initial position setting is normally completed. However, the technique of the present disclosure is not limited thereto. For example, the initial position setting may be automatically stored in the memory 204 by the controller 200 without receiving an operation by the manipulator 212 from the operator.

For example, in the above description, the program is stored in the memory 204. However, a method of providing the program according to the present disclosure is not limited thereto. For example, the program may be recorded in a computer-readable recording medium and provided together with the recording medium.

Even in the modified examples described above, it is possible to suppress the decrease in the work efficiency in the initial position setting operation for the substrate processing apparatus 10.

For example, the embodiments mentioned above are described by way of an example in which a batch type substrate processing apparatus capable of simultaneously processing a plurality of substrates is used to form the film. However, the technique of the present disclosure is not limited thereto. For example, the technique of the present disclosure may be preferably applied when a single wafer type substrate processing apparatus capable of simultaneously processing one or several substrates is used to form the film. For example, the embodiments mentioned above are described by way of an example in which a substrate processing apparatus including a hot wall type process furnace is used to form the film. However, the technique of the present disclosure is not limited thereto. For example, the technique of the present disclosure may be preferably applied when a substrate processing apparatus including a cold wall type process furnace is used to form the film.

The process procedures and the process conditions of each process using the substrate processing apparatuses exemplified above may be substantially the same as those of the embodiments or the modified examples mentioned above. Even in such a case, it is possible to obtain substantially the same effects as in the embodiments or the modified examples mentioned above.

### <Other Modified Examples>

While the embodiments mentioned above are described by way of an example in which the substrate processing apparatus 10 constitutes a batch and vertical type CVD apparatus, the technique of the present disclosure is not limited thereto. For example, the technique of the present disclosure may also be applied to a semiconductor manufacturing apparatus such as a batch and vertical type diffusion apparatus.

While the embodiments mentioned above are described by way of an example in which the container 4 is used as the substrate container configured to store the substrates 2, the technique of the present disclosure is not limited thereto. For example, as the substrate container, a cassette which does not include a cap (or a lid) may be used. When the cassette is used as the substrate container, it is possible to omit an installation operation for the container opening/closing apparatus 62.

For example, a loading structure through which the substrate is loaded into the substrate processing apparatus main structure 12 and an unloading structure through which the substrate is unloaded out of the substrate processing apparatus main structure 12 may be provided separately instead of the loading/unloading structure 14, and the transfer structure 22 may be provided at one or both of the loading structure and the unloading structure.

Further, the substrate loading port structures 60 are not limited to the upper and lower substrate loading port structures arranged in two stages. For example, instead of the substrate loading port structures 60 arranged in two stages, a substrate loading port structure may be arranged in one stage alone. For example, as the substrate loading port structures 60, three or more substrate loading port structures arranged in three or more stages (such as an upper stage, a middle stage and a lower stage) may be provided.

The invention may be summarized as follows: It is possible to suppress a decrease in work efficiency in an initial position setting operation for a substrate processing apparatus. There is provided a technique that includes: transporters each provided with one or more transfer shafts; a manipulator for selecting a specified transfer shaft from the one or more transfer shafts and performing an initial position setting therefor; a display for displaying a status of the initial position setting for the specified transfer shaft; and a controller including a determination processor and notifying a determination result determined by the determination processor, wherein the determination processor determines whether the initial position setting for the specified transfer shaft selected by the manipulator is completed and whether it is possible for an initial position setting for another transfer shaft to be performed in parallel.

### [Description of Reference Numerals]

| | | | |
|---|---|---|---|
| 2: | Substrate | 4: | Container |
| 10: | Substrate processing apparatus | | |
| 50: | Container storage shelf (transport structure) | | |
| 70: | Container transfer apparatus (transport structure) | | |
| 100: | Support structure transfer apparatus (transport str ucture) | | |
| 110: | substrate transfer apparatus (transport structure) | | |
| 200: | Controller | 203: | Determination processor |
| 212: | Manipulator | 213: | Display |

## Claims

1. A substrate processing apparatus comprising:
a plurality of transporters each provided with one or more transfer shafts and configured to transfer a substrate or a container accommodating the substrate;
a manipulator configured to be capable of selecting a specified transfer shaft from the one or more transfer shafts and capable of performing an initial position setting for the specified transfer shaft;
a display configured to display a status of the initial position setting for the specified transfer shaft; and
a controller provided with a determination processor and configured to be capable of notifying a determination result determined by the determination processor,
wherein the determination processor is configured to determine whether or not the initial position setting for the specified transfer shaft selected by the manipulator is completed and to determine whether or not it is possible for an initial position setting for another transfer shaft to be performed in parallel with the initial position setting for the specified transfer shaft.

2. The substrate processing apparatus of claim 1, wherein the determination processor is further configured to determine whether or not it is possible for the initial position setting for the another transfer shaft to be performed based on whether or not an initial position setting for a predetermined transfer shaft among the one or more transfer shafts has been completed.

3. The substrate processing apparatus of claim 1 and/or 2, wherein the determination processor is further configured to determine whether or not it is possible for the initial position setting for the another transfer shaft to be performed based on predefined parameters and a state of the specified transfer shaft selected by the manipulator.

4. The substrate processing apparatus of any one or more of claims 1 to 3, wherein the plurality of transporters comprise:
a container transfer apparatus configured to transfer the container placed on a shelf or configured to place the container on the shelf;
a container storage shelf configured to store the container by the container transfer apparatus;
a substrate transfer apparatus configured to take out the substrate from the container transferred by the container transfer apparatus or configured to accommodate the substrate in the container; and
a support structure transfer apparatus configured to move the substrate received from the substrate transfer apparatus into a process vessel.

5. The substrate processing apparatus of any one or more of claims 1 to 4, wherein the one or more transfer shafts of a transporter among the plurality of transporters comprise at least one among a left-right shaft capable of moving in a left-right direction, a front-rear shaft capable of moving in a front-rear direction, a vertical shaft capable of moving in an up-down direction and a rotation shaft capable of rotating.

6. The substrate processing apparatus of any one or more of claims 1 to 5, wherein the manipulator is further configured to be capable of further selecting one or more specified transfer shafts.

7. The substrate processing apparatus of claim 6, wherein the controller is further configured to be capable of controlling the specified transfer shaft and the one or more specified transfer shafts selected by the manipulator such that initial position setting operations for the specified transfer shaft and the one or more specified transfer shafts are performed in parallel.

8. The substrate processing apparatus of any one or more of claims 1 to 7, wherein the display is further configured to display a plurality of items of the one or more transfer shafts.

9. The substrate processing apparatus of claim 8, wherein, when an item among the plurality of items is selected, the specified transfer shaft corresponding to the item is selected.

10. The substrate processing apparatus of claim 9, wherein the display is provided with a transfer shaft selection area in which the plurality of items are capable of being aligned and displayed, and
wherein the controller is capable of controlling the display such that the item of the specified transfer shaft which is selected is displayed differently from an item of another transfer shaft which is not selected.

11. The substrate processing apparatus of claim 10, wherein the display is further provided with a work procedure display area in which a work procedure of the initial position setting for the specified transfer shaft which is selected is displayed, and
wherein the controller is further configured to align and display a plurality of work items indicating an initial position setting work of the specified transfer shaft which is selected in the transfer shaft selection area.

12. The substrate processing apparatus of claim 11, wherein the controller is further configured to be capable of controlling the display to display a work item representing a work being performed in the work procedure display area so as to be different from other work items.

13. The substrate processing apparatus of any one or more of claims 1 to 12, wherein the display is further configured to be capable of displaying one or more states among a state in which a line of each transfer shaft is disconnected, a state in which the initial position setting for each transfer shaft is incomplete and a state in which the initial position setting for each transfer shaft is complete.

14. A method of manufacturing a semiconductor device, comprising
(a) selecting a specified transfer shaft from one or more transfer shafts by using a manipulator, wherein the one or more transfer shafts are provided at a plurality of transporters configured to transfer a substrate or a container accommodating the substrate;
(b) performing an initial position setting for the specified transfer shaft by using the manipulator;
(c) determining whether or not the initial position setting for the specified transfer shaft selected by the manipulator is completed and determining whether or not it is possible for an initial position setting for another transfer shaft to be performed in parallel with the initial position setting for the specified transfer shaft;
(d) notifying a determination result in (c); and
(e) transferring the substrate by the specified transfer structure selected in (a).

15. A program that causes a substrate processing apparatus, by a computer, to perform:
(a) selecting a specified transfer shaft from one or more transfer shafts by using a manipulator, wherein the one or more transfer shafts are provided at a plurality of transporters configured to transfer a substrate or a container accommodating the substrate;
(b) performing an initial position setting for the specified transfer shaft by using the manipulator;
(c) determining whether or not the initial position setting for the specified transfer shaft selected by the manipulator is completed and determining whether or not it is possible for the initial position setting for another transfer shaft to be performed in parallel with the initial position setting for the specified transfer shaft;
(d) notifying a determination result in (c); and
(e) transferring the substrate by the specified transfer structure selected in (a).
